# EUROPÄISCHE PATENTSCHRIFT

(11) **EP 3 592 486 B1**
(45) Veröffentlichungstag und Bekanntmachung des Hinweises auf die Patenterteilung: **24.04.2024**
(21) Anmeldenummer: 18708632.7
(22) Anmeldetag: 26.02.2018
(51) Int. Cl.: H01J 37/305, B29C 64/153, B29C 64/268, B33Y 10/00, B33Y 30/00, B22F 3/105, B22F 10/28, B22F 12/41

(54) **ELEKTRONENSTRAHLANLAGE SOWIE VERFAHREN ZUM BEARBEITEN VON PULVERFÖRMIGEM WERKSTOFF**
ELECTRON BEAM INSTALLATION AND METHOD FOR WORKING POWDERED MATERIAL
INSTALLATION À FAISCEAU D'ÉLECTRONS ET PROCÉDÉ DE TRAITEMENT D'UN MATÉRIAU PULVÉRULENT

(30) Priorität: 10.03.2017 DE 102017105193
(43) Veröffentlichungstag der Anmeldung: 15.01.2020
(73) Patentinhaber: pro-beam GmbH & Co. KGaA, 82205 Gilching (DE)
(72) Erfinder: HANSEN, Björn, 82140 Olching (DE); HUBER, Gerhard, 84155 Bodenkirchen (DE); LÖWER, Thorsten, 80339 München (DE)
(74) Vertreter: Ostertag & Partner Patentanwälte mbB
(86) Internationale Anmeldenummer: PCT/EP2018/054608
(87) Internationale Veröffentlichungsnummer: WO 2018/162261

(56) Entgegenhaltungen:
- EP-A1- 3 178 586
- EP-A1- 3 363 564
- DE-A1-102015 214 994
- DE-B3-102015 201 796
- JP-A- 2015 176 685
- US-A1- 2014 370 323

## Beschreibung

### HINTERGRUND DER ERFINDUNG

### 1. Gebiet der Erfindung

Die Erfindung betrifft eine Elektronenstrahlanlage, die zur Bearbeitung von pulverförmigem Werkstoff verwendet wird, mit
a) einem Pulverbehältnis, welches ein Pulverbett aus dem zu bearbeitenden pulverförmigen Werkstoff aufnehmen kann, und mit
b) einem Elektronenstrahlerzeuger, der dazu eingerichtet ist, einen Elektronenstrahl auf lateral unterschiedliche Orte des Pulverbettes zu richten.

Die Erfindung betrifft ferner ein Verfahren zum Bearbeiten von pulverförmigem Werkstoff mit einer solchen Elektronenstrahlanlage.

### 2. Beschreibung des Standes der Technik

In jüngster Zeit werden Werkstücke häufig durch sogenannte 3D-Druckverfahren erzeugt. Dabei kommen unter anderem 3D-Druckverfahren zur Anwendung, bei welchen beispielsweise mit einem Laserstrahl ein pulverförmiger Werkstoff in einem Pulverbett durch selektives Verschmelzen der einzelnen Pulverpartikel insbesondere Punkt für Punkt und Schicht für Schicht zu einer 3D-Struktur verbunden wird.

In Anlehnung an derartige 3D-Druckverfahren wurden entsprechende Versuche auch mit Elektronenstrahlanlagen durchgeführt. Dabei hat sich jedoch gezeigt, dass der auftreffende Elektronenstrahl bei bestimmten pulverförmigen Werkstoffen die Pulverpartikel aus dem Pulverbett zu einem Großteil verbläst, d.h. aus dem Pulverbett in andere Bereiche der Elektronenstrahlanlage verteilt wird, bevor der Verschmelzungsprozess eintritt. Daher ist es nach aktuellem Stand der Technik bekannt, nachdem eine weitere Schicht des pulverförmigen Werkstoffs in Form des Pulverbettes aufgetragen wurde dieses vorzuwärmen, um die einzelnen Pulverpartikel unter gegenüber dem Endprodukt geringerer Adhäsion miteinander zu verbinden.

Erst in einem zweiten Schritt werden dann die Pulverpartikel entlang der jeweils zu generierende Konturschicht einer 3D-Struktur mit dem Elektronenstrahl soweit aufgeschmolzen, dass eine für den späteren Verwendungszweck des Werkstücks ausreichende Stabilität der 3D-Struktur zwischen den einzelnen Pulverpartikeln hergestellt wird.

Die Nachteile dieses Verfahrens zeigen sich in der notwendigen Prozesszeit für das Aufheizen des Pulverbetts, da das Aufheizen insbesondere für jede einzelne aufgetragene Pulverschicht erneut zu erfolgen hat. Zudem muss die zusätzliche Wärme in das Vakuumsystem der Elektronenstrahlanlage eingebracht werden, wodurch ein erhöhter Energiebedarf und eine komplexere Prozessführung notwendig ist.

Aus der nachveröffentlichten EP 3 363 564 A1 ist eine Elektronenstrahlanlage bekannt, bei der mit Hilfe zweier Elektroden kurze Spannungsspitzen oder elektromagnetische Wellen in ein Pulverbett eingebracht werden, um die elektrische Verbindung zwischen den Partikeln des Pulverbetts zu verbessern.

Die ebenfalls nachveröffentlichte EP 3 178 586 A1 beschreibt ein Verfahren zur Metallpulverbearbeitung, bei dem durch Anlegen einer Wechselspannung unter gleichzeitigem Zudosieren von Stickstoffgas das Metallpulver nitriert wird, um ein anschließend aus dem Metallpulver per selektivem Verschmelzen entstehendes Objekt zu härten.

Aus der JP 2015 176685 A ist eine Elektronenstrahlanlage bekannt, bei der die Leistung des Elektronenstrahls zwischen einem Schmelzmodus und einem Detektionsmodus hin- und herwechselt, sodass eine Überwachung des Herstellungsprozesses quasi zeitgleich zum Schmelzvorgang erfolgt.

### ZUSAMMENFASSUNG DER ERFINDUNG

Aufgabe der Erfindung ist es daher, eine Elektronenstrahlanlage eingangs genannter Art anzugeben, welche das Problem des Verblasens des pulverförmigen Werkstoffs bei der Bearbeitung mit dem Elektronenstrahl besser löst. Aufgabe der Erfindung ist es ferner, ein entsprechendes Verfahren zum Bearbeiten des pulverförmigen Werkstoffs anzugeben.

Erfindungsgemäß wird diese Aufgabe durch eine Elektronenstrahlanlage nach Anspruch 1 gelöst.

Die Erfinder haben erkannt, dass das aus der älteren Telegrafentechnik bekannte Prinzip eines Fritters (von "fritten" = zusammenbacken), auch Kohärer genannt, auf den pulverförmigen Werkstoff des Pulverbetts einer Elektronenstrahlanlage für Zwecke des 3D-Drucks anwendbar ist.

Dazu haben die Erfinder zunächst erkannt, dass das Verblasen des pulverförmigen Werkstoffs sehr wahrscheinlich auf die elektrostatische Abstoßung der Pulverpartikel voneinander zurückgeht, wenn die Pulverpartikel mit dem Elektronenstrahl beschossen werden und sich dabei elektrostatisch aufladen. Dabei hat sich herausgestellt, dass das Verblasen entgegen naheliegender Überlegungen auch bei Werkstoffen auftritt, die aus einem leitfähigen Material, wie beispielsweise Metallpulverpartikeln bestehen. Dies ist erklärbar dadurch, dass die kleinen Metallpulverpartikel häufig von einer Oxidschicht umgeben sind, welche nicht leitfähig ist. Daher kann sich ein solches Metallpulverpartikel obwohl es in seinem Inneren leitfähig ist beim Eintreffen des Elektronenstrahls elektrisch aufladen und somit das Verblasen bewirken.

Durch das Einbringen einer elektromagnetischen Wechselspannung kann zwischen aneinander angrenzenden Pulverpartikeln die sogenannte Fritt-Spannung überschritten werden, ohne dass es zu einer elektrostatischen Aufladung kommt. Ähnlich wie bei dem aus der Telegrafentechnik bekannten Fritter werden durch den dabei fließenden Fritt-Strom die einzelnen Pulverpartikel miteinander verbunden. Das Verfahren ist somit besonders geeignet zur Verwendung mit metallischem Pulver als pulverförmigem Werkstoff.

Die Fritt-Einrichtung kann somit die bekannte Temperaturführung des Pulverbettes zum Zwecke der Verhinderung oder zumindest der Reduktion des Verblasens ersetzen oder ergänzen. Dadurch kann unter anderem eine zeitliche Reduktion der Abkühlphase und eine Energieeinsparung der Anlage erreicht werden. Da gegenüber der 3D-Struktur überschüssiger pulverförmiger Werkstoff, aus welchem die 3D-Struktur am Ende entnommen wird, zumeist wiederverwendet wird, kann durch die Verwendung der Fritt-Einrichtung zudem die Alterungsgeschwindigkeit des Werkstoffs verringert werden.

Das elektromagnetische Wechselfeld der Fritt-Einrichtung soll dabei den pulverförmigen Werkstoff des Pulverbetts zumindest soweit verbinden, dass bei einer nachfolgenden Bearbeitung mit dem Elektronenstrahl das Verblasen des pulverförmigen Werkstoffs reduziert ist. Die Pulverpartikel werden also nur leicht miteinander verbacken (gefrittet). Im Gegensatz dazu ist unter der Bearbeitung insbesondere ein selektives, insbesondere punktuelles Verschmelzen des pulverförmigen Werkstoffs zu verstehen, um zu einer stabilen 3D-Struktur zu gelangen. Je nach Scanstrategie kann diese beispielsweise Punkt für Punkt, Linie für Linie und Schicht für Schicht erzeugt werden.

Erfindungsgemäß liegen die Frequenzen, mit welchen die Wechselspannung der Fritt-Einrichtung betrieben werden, in Bereichen größer als 5 kHz, insbesondere größer als 10 kHz, vorzugsweise größer als 50 kHz. Die Spannungen und Abstände der Elektroden können dabei insbesondere so gewählt sein, dass Feldstärken größer als 0,5 kV/mm, insbesondere größer als 1 kV/mm, vorzugsweise größer als 10 kV/mm im Pulverbett auftreten.

Erfindungsgemäß sind die Leistung und/oder die Frequenz der Wechselspannung der Fritt-Einrichtung und die Leistung des Elektronenstrahls so gewählt, dass der verbundene pulverförmige Werkstoff bei einer nachfolgenden Bearbeitung mit dem Elektronenstrahl, insbesondere bei einem nachfolgenden Verschmelzen mit dem Elektronenstrahl, nicht Verblasen wird, wobei der pulverförmige Werkstoff an Orten, an welchen keine Bearbeitung mit dem Elektronenstrahl erfolgt, durch die Fritt-Einrichtung nur so verbunden wird, dass der pulverförmige Werkstoff dort, insbesondere durch Anstoßen, wieder gelöst werden kann. Insbesondere soll der pulverförmige Werkstoff an nicht bearbeiteten Stellen leichter lösbar sein, als der an bearbeiteten Stellen.

Für die Anordnung der Elektroden der Fritt-Einrichtung sind verschiedene Varianten denkbar, wobei die Elektroden insbesondere im elektrischen Kontakt mit dem Pulverbett stehen können. Eine Elektrode der Fritt-Einrichtung kann sogar zugleich zum Ableiten der vom Elektronenstrahl bei der Bearbeitung eingebrachten Ladung herangezogen werden.

Vorzugsweise ist zumindest eine Elektrode der Fritt-Einrichtung an einer festen Position innerhalb der Elektronenstrahlanlage angeordnet.

Vorzugsweise sind zumindest zwei Elektroden waagrecht in einer zu einer obersten Pulverschicht des Pulverbetts parallelen, insbesondere der gleichen, Ebene angeordnet sind. Auf diese Weise kann der pulverförmige Werkstoff schichtweise leicht verbacken werden. Wenn dabei die einzelnen Schichten sich nicht miteinander verbinden, lässt sich nach der Bearbeitung mit dem Elektronenstrahl der pulverförmige Werkstoff, der nicht zu einer 3D-Struktur verbunden wurde, leichter lösen.

Vorzugsweise sind zumindest zwei Elektroden der Fritt-Einrichtung symmetrisch zu einem lateralen Bereich angeordnet sind, in welchem der Elektronenstrahl auf das Pulverbett gerichtet werden kann. Die laterale Richtung bezieht sich dabei auf eine Richtung quer zur Strahlrichtung.

Zumindest zwei Elektroden können aber auch in einer Ebene senkrecht zur obersten Pulverschicht des Pulverbetts angeordnet sein. Dabei kann zumindest eine Elektroden der Fritt-Einrichtung dazu eingerichtet sein, entlang mindestens einer Achse über das Pulverbett bewegt zu werden. Dies erfolgt vorzugsweise in einem definierten Abstand zum Pulverbett. Ferner kann die Elektrode der Fritt-Einrichtung vorzugsweise im Nachlauf zu einer Pulverauftrag-Einrichtung wie z.B. einer Rakel, mit welcher der pulverförmige Werkstoff als Pulverbett aufgetragen wird, über das Pulverbett bewegt werden. Konkret kann die Elektrode beispielsweise über einen Draht realisiert sein, der über das Pulverbett bewegt wird. Vorzugsweise oder alternativ kann auch eine Bewegung entlang zweier Achsen vorgesehen sein.

Vorzugsweise weist das Pulverbehältnis einen Pulverbett-Tischboden auf, der elektrisch leitfähig ist und zugleich eine Elektrode der Fritt-Einrichtung ausbildet. Der Tischboden stellt eine große Kontaktfläche dar. Insbesondere kann der Tischboden auch als Elektrode zum Ableiten der vom Elektronenstrahlerzeuger eingebrachten Ladung dienen.

Vorzugsweise ist zumindest eine Elektrode der Fritt-Einrichtung durch den Elektronenstrahl selbst ausgebildet, wobei der Elektronenstrahl mit Wechselspannung beschleunigt wird. Bei diesen Erfindungsgedanken reduziert sich der Zusatzaufwand für eine Fritt-Einrichtung im Wesentlichen auf ein entsprechendes Fritt-Steuermodul in der Anlagensteuerung.

Im Hinblick auf das Verfahren wird die Erfindung durch ein Verfahren nach Anspruch 8 gelöst.

Vorzugsweise ist der pulverförmige Werkstoff dabei ein metallisches Pulver und das Bearbeiten in Schritt c) ist ein Miteinander-Verschmelzen von Partikeln des pulverförmigen Werkstoffs, derart, dass durch das selektive Verschmelzen nach und nach eine 3D-Struktur erzeugt wird. Dadurch lassen sich mit einer Elektronenstrahlanlage im 3D-Druckverfahren 3D-Strukturen erzeugen.

Die Verwendung einer Elektronenstrahlanlage für den 3D-Druck hat insbesondere den Vorteil, dass in etwa 1000 mal höhere Ablenkgeschwindigkeiten für den Elektronenstrahl erreichbar sind als für einen Laserstrahl. Dies führt zu neuartigen Belichtungsstrategien, die zu höherer Produktivität, einem thermisch optimierteren Prozess und/oder einem geringeren Verzug der 3D-Struktur führen und sogar Einfluss auf die Ausgestaltung der damit erzeugten 3D-Strukturen haben können.

### KURZE BESCHREIBUNG DER ZEICHNUNGEN

Nachfolgend werden Ausführungsbeispiele der Erfindung anhand der Zeichnungen näher erläutert. In diesen zeigen:
- Figur 1: eine perspektivische Ansicht einer erfindungsgemäßen Elektronenstrahlanlage mit einem Pulverbett-Tischboden als Pulverbehältnis und einer Fritt-Einrichtung;
- Figur 2: eine Schnittansicht einer Elektronenstrahlanlage nach einem zweiten Ausführungsbeispiel mit einem anderweitig ausgestalteten Pulverbehältnisses für das Pulverbett;
- Figur 3: eine Erläuterungsdarstellung zum Vorgang des Frittens.

### BESCHREIBUNG BEVORZUGTER AUSFÜHRUNGSBEISPIELE

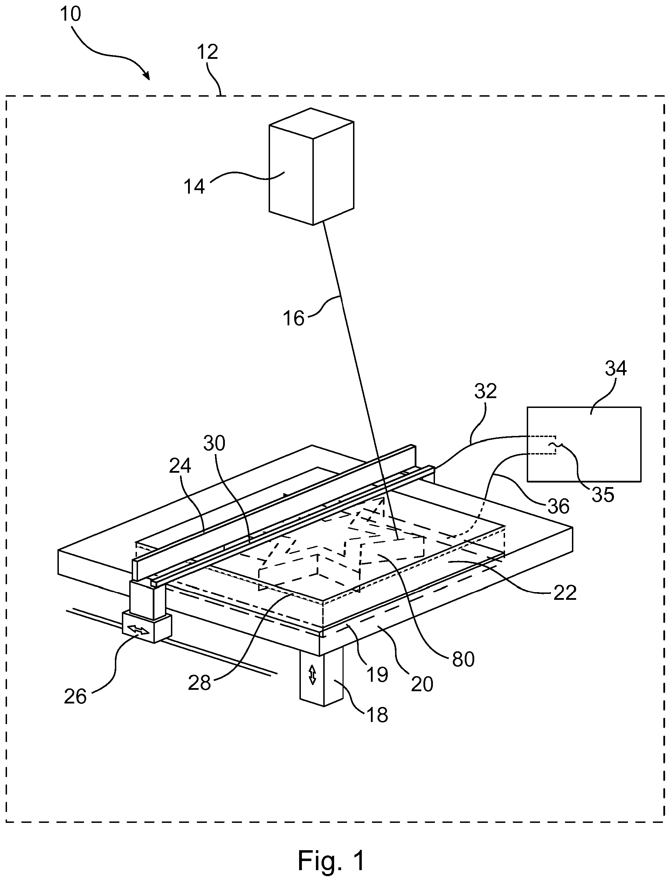

Figur 1 zeigt eine Elektronenstrahlanlage 10 mit einem Vakuumgehäuse 12, in welchem eine Elektronenstrahlkanone 14 zur Erzeugung eines Elektronenstrahls 16 angeordnet ist.

Im vorliegenden Ausführungsbeispiel ist die Elektronenstrahlkanone 14 oberhalb eines Hubtisches 18 mit einer elektrisch leitfähigen Hubplatte 19 und mit einem Aufnahmerahmen 20 angeordnet, der als räumlich begrenztes Pulverbehältnis dient, welches ein Pulverbett 22 aus einem zu bearbeitenden pulverförmigen Werkstoff aufnimmt. Zur weiteren seitlichen Begrenzung des Pulverbettes 22 können dabei weitere hier nicht gezeigte Seitenwände vorgesehen sein.

Wird die Hubplatte 19 nach unten gefahren, kann das Pulverbett 22 nach und nach einen größer werdenden Bereich einnehmen, sodass das Pulverbett 22 Schicht für Schicht vergrößert wird.

Oberhalb des Aufnahmerahmens 20 ist dazu eine Pulverauftrageinrichtung 24 mit einer Rakel angeordnet, die mit einer Verfahreinrichtung 26 über den Hubtisch 18 bewegt werden kann. Die Pulverauftrageinrichtung 24 weist einen nicht gezeigten Behälter für den pulverförmigen Werkstoff auf, aus welchem durch eine Verfahrbewegung jeweils als oberste lose Schicht 28 der Werkstoff auf dem Pulverbett 22 eben aufgerakelt werden kann.

Die Verfahreinrichtung 26 trägt ferner im hier gezeigten Ausführungsbeispiel zugleich eine Fritt-Elektrodenschiene 30, die über eine elektrische Leitung 32 an einem Fritt-Steuergerät 34 angeschlossen ist. Die Fritt-Elektrodenschiene 30 kann jedoch auch anderweitig über das Pulverbett 22 hinweg bewegt werden.

Über eine andere elektrische Leitung 36 ist das Fritt-Steuergerät 34 hingegen mit der Hubplatte 19 als Gegenelektrode verbunden.

Das Fritt-Steuergerät 34 weist eine Wechselspannungsquelle 35 auf, mit welcher die Fritt-Elektrodenschiene 30 als erste Elektrode und die Hubplatte 19 als zweite Elektrode mit Wechselspannung beaufschlagbar sind.

Die Fritt-Elektrodenschiene 30, die Hubplatte 19 sowie das Fritt-Steuergerät 34 bilden zusammen eine Fritt-Einrichtung, die noch weitere Bauteile umfassen kann und deren Zweck nachfolgend noch deutlicher erläutert wird.

Mit dem Bezugszeichen 80 ist in Figur 1 ferner eine beispielhaft als Stern dargestellte 3D-Struktur bezeichnet, die durch Verschmelzen einzelner Partikel im Pulverbett 22 mit Hilfe des Elektronenstrahls 16 nach und nach ausgebildet bzw. "gedruckt" wurde.

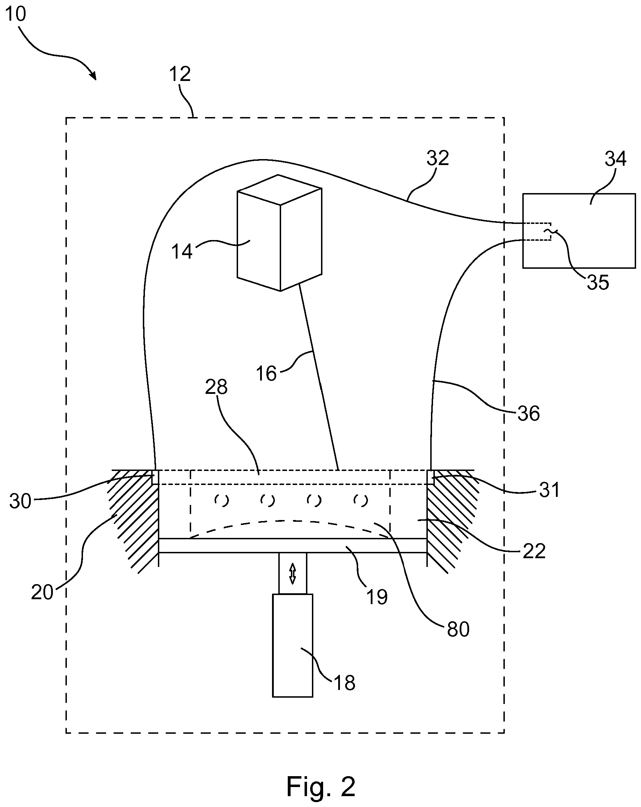

Ein abgewandeltes Ausführungsbeispiel der Elektronenstrahlanlage 10 ist in Figur 2 gezeigt, wobei funktionelle oder strukturell ähnliche Bauteil mit demselben Bezugszeichen wie in Figur 1 bezeichnet sind.

In Figur 2 ist in einem Schnitt der Hubtisch 18 mit einer hier nicht notwendigerweise elektrisch leitfähigen Hubplatte 19 zu erkennen.

Der Aufnahmerahmen 20 trägt hier jedoch an seinem oberen Ende auf einer Seite des Pulverbett 22 eine erste leistenförmige Fritt-Seitenelektrode 30, die über die Leitung 32 mit dem Fritt-Steuergerät 34 verbunden ist. Eine zugehörige Gegenelektrode ist als zweite Fritt-Seitenelektrode 31 auf der lateral gegenüberliegenden Seite des Pulverbetts 22 angeordnet und ist über die Leitung 36 mit dem Fritt-Steuergerät 34 verbunden. Die Fritt-Seitenelektroden 30, 31 sind damit beidseits eines lateralen Bereichs angeordnet, auf welchen der Elektronenstrahl 16 gerichtet werden kann.

Ferner ist aus Figur 2 deutlich eine 3D Struktur 80 erkennbar, die auch in senkrechter Richtung zur horizontalen Fläche des Pulverbetts 22 mit Ausnehmungen und Wölbungen komplexer strukturiert ist.

Schließlich ist bei diesem Ausführungsbeispiel das Fritt-Steuergerät 34 außerhalb des Vakuumgehäuses 12 angeordnet.

Die erfindungsgemäße Elektronenstrahlanlage 10 arbeitet wie folgt:
Zunächst wird mit der Pulverauftrageinrichtung 24 die oberste lose Schicht 28 aus pulverförmigem Werkstoff aufgetragen. Im Nachlauf zur Bewegung der Pulverauftrageinrichtung 24 noch während der Bewegung oder auch anschließend an die Bewegung wird mit dem Fritt-Steuergerät 34 dann eine Wechselspannung zwischen den Elektroden 30, 31 und 19 angelegt.

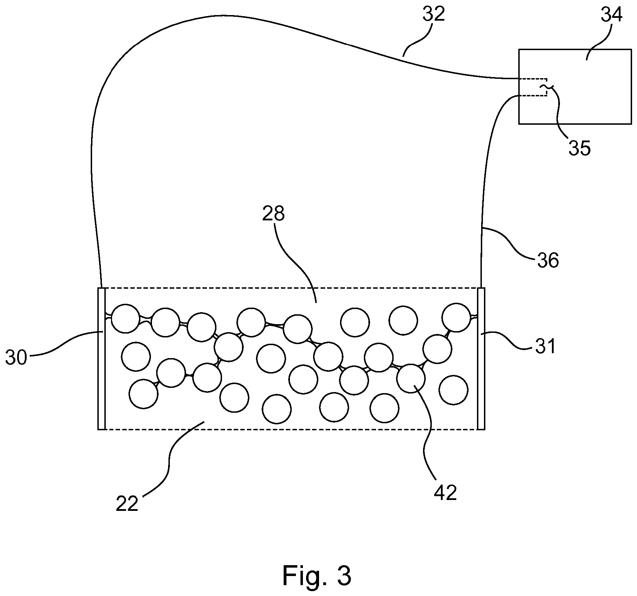

Mit einer Wechselspannung, deren Frequenz und Leistung angepasst an den pulverförmigen Werkstoff entsprechend gewählt ist, werden dann wie aus Figur 3 ersichtlich einzelne Pulverpartikel 42 der losen Schicht 28 des Pulverbetts 22 durch leichtes Anschmelzen miteinander verbunden. Wie in Figur 3 anhand der Filterhälse zwischen den Pulverpartikeln zu erkennen ist, entsteht dadurch eine Kette von Pulverpartikeln 42, die eine höhere bzw. durchgängigere elektrische Leitfähigkeit aufweist, als die losen Pulverpartikel 42 im Pulverbett 22.

Bei diesem Vorgang werden die Pulverpartikel 42 nicht aus dem Pulverbett 22 verblasen, da aufgrund der Wechselspannung die Pulverpartikel 42 nicht elektrostatisch aufgeladen werden und dennoch ein ausreichend hoher Frittstrom erzeugt werden kann, der zumindest einen Teil der Pulverpartikel 42 schmelzen und miteinander "verbacken" lässt.

Anschließend wird mit der Elektronenstrahlkanone 14 durch stärkeres Schmelzen der Pulverpartikel 42 an durch die zu erzeugende 3D-Struktur 80 vorgegebenen Stellen des über die Fritt-Einrichtung präparierten Pulverbetts 22 bzw. dessen obersten losen Schicht 28 ein festere Verbindung erzeugt. Fester bedeutet in diesem Zusammenhang, dass an den durch den Elektronenstrahl 16 bearbeiteten Stellen die Pulverpartikel 42 beispielsweise derart fester miteinander verbunden sind, dass die 3D-Struktur 80 durch Abklopfen der nur gefritteten Pulverpartikel 42 aus dem Pulverbett 22 entnommen werden kann.

Die oben beschriebenen Schritte werden jeweils Schicht um Schicht wiederholt bis die 3D-Struktur 80 beendet ist.

## Patentansprüche

1. Elektronenstrahlanlage (10), die zum selektiven Verschmelzen von pulverförmigem Werkstoff verwendet wird, um zu einer stabilen 3D-Struktur (80) zu gelangen, mit
a) einem Pulverbehältnis (18, 19, 20), welches ein Pulverbett (22) aus dem zu bearbeitenden pulverförmigen Werkstoff aufnehmen kann, und mit
b) einem Elektronenstrahlerzeuger (14), der dazu eingerichtet ist, einen Elektronenstrahl (16) auf lateral unterschiedliche Orte des Pulverbettes (22) zu richten,
**dadurch gekennzeichnet, dass**
c) die Elektronenstrahlanlage (14) eine Fritt-Einrichtung (34, 35) mit mindestens zwei Elektroden (19, 30, 31) aufweist, welche durch Anlegen einer Wechselspannung zwischen den mindestens zwei Elektroden (19, 30, 31) zumindest bereichsweise über das Pulverbett (22) hinweg ein elektromagnetisches Wechselfeld erzeugt, welches den pulverförmigen Werkstoff des Pulverbetts (22) verbindet, wobei
d) die Leistung und/oder die Frequenz der Wechselspannung der Fritt-Einrichtung (34, 35) und die Leistung des Elektronenstrahls (16) so gewählt sind, dass der verbundene pulverförmige Werkstoff beim nachfolgenden Verschmelzen mit dem Elektronenstrahl (16) nicht Verblasen wird, wobei der pulverförmige Werkstoff an Orten, an welchen keine Bearbeitung mit dem Elektronenstrahl (16) erfolgt, durch die Fritt-Einrichtung (34, 35) nur so verbunden wird, dass der pulverförmige Werkstoff dort, insbesondere durch Anstoßen, wieder gelöst werden kann, und wobei
e) die Frequenz der Wechselspannung der Fritt-Einrichtung in Bereichen größer als 5 kHz liegt.

2. Elektronenstrahlanlage nach Anspruch 1, **dadurch gekennzeichnet, dass** zumindest eine Elektrode (19, 31) der Fritt-Einrichtung (34, 35) an einer festen Position innerhalb der Elektronenstrahlanlage (10) angeordnet ist.

3. Elektronenstrahlanlage nach einem der vorhergehenden Ansprüche, **dadurch gekennzeichnet, dass** zumindest zwei Elektroden (30, 31) waagrecht in einer zu einer obersten Pulverschicht (28) des Pulverbetts (22) parallelen, insbesondere der gleichen, Ebene angeordnet sind.

4. Elektronenstrahlanlage nach einem der vorhergehenden Ansprüche, **dadurch gekennzeichnet, dass** zumindest zwei Elektroden (30, 31) der Fritt-Einrichtung (34, 35) symmetrisch zu einem lateralen Bereich angeordnet sind, in welchem der Elektronenstrahl (16) auf das Pulverbett (22) gerichtet werden kann.

5. Elektronenstrahlanlage nach einem der vorhergehenden Ansprüche, **dadurch gekennzeichnet, dass** zumindest eine Elektrode (30) der Fritt-Einrichtung (34, 35) dazu eingerichtet ist, entlang mindestens einer Achse über das Pulverbett (22) bewegt zu werden.

6. Elektronenstrahlanlage nach einem der vorhergehenden Ansprüche, **dadurch gekennzeichnet, dass** das Pulverbehältnis (18, 19, 20) einen Pulverbett-Tischboden (19) aufweist, der elektrisch leitfähig ist und zugleich eine Elektrode der Fritt-Einrichtung (34, 35) ausbildet.

7. Elektronenstrahlanlage nach einem der vorhergehenden Ansprüche, **dadurch gekennzeichnet, dass** zumindest eine Elektrode der Fritt-Einrichtung (34, 35) durch den Elektronenstrahl (16) selbst ausgebildet ist, indem der Elektronenstrahlerzeuger (14) gepulst betrieben und/oder der Elektronenstrahl mit hoher Ablenkgeschwindigkeit abgelenkt wird.

8. Verfahren zum selektiven Verschmelzen von pulverförmigem Werkstoff mit einer Elektronenstrahlanlage (10), um zu einer stabilen 3D-Struktur (80) zu gelangen, mit folgenden Schritten:
a) Bereitstellen einer Elektronenstrahlanlage (10) mit
- einem Pulverbehältnis (18, 19, 20), welches ein Pulverbett (22) aus dem zu bearbeitenden pulverförmigen Werkstoff aufnehmen kann, und mit
- einem Elektronenstrahlerzeuger (14), der dazu eingerichtet ist, einen Elektronenstrahl (16) auf lateral unterschiedliche Orte des Pulverbettes (22) zu richten;
b) Anlegen einer Wechselspannung zwischen mindestens zwei Elektroden (19, 30, 31) mit einer Fritt-Einrichtung (34, 35), um zumindest bereichsweise über das Pulverbett (22) hinweg ein elektromagnetisches Wechselfeld zu erzeugen, welches den pulverförmigen Werkstoff des Pulverbetts (22) verbindet, wobei die Leistung und/oder die Frequenz der Wechselspannung der Fritt-Einrichtung (34, 35) und die Leistung des Elektronenstrahls (16) so gewählt sind, dass der verbundene pulverförmige Werkstoff beim nachfolgenden Verschmelzen mit dem Elektronenstrahl (16) nicht Verblasen wird, wobei der pulverförmige Werkstoff an Orten, an welchen keine Bearbeitung mit dem Elektronenstrahl (16) erfolgt, durch die Fritt-Einrichtung (34, 35) nur so verbunden wird, dass der pulverförmige Werkstoff dort, insbesondere durch Anstoßen, wieder gelöst werden kann, wobei die Frequenz der Wechselspannung der Fritt-Einrichtung in Bereichen größer als 5 kHz liegt;
c) Selektives Verschmelzen des pulverförmigen Werkstoffs mit dem Elektronenstrahl (16).

## Claims

1. An electron beam installation (10), which is used for selective melting of powdered material to get a stable 3D structure (80), comprising
a) a powder container (18, 19, 20), which can accommodate a powder bed (22) made of the powdered material to be processed, and comprising
b) an electron beam generator (14), which is configured to direct an electron beam (16) onto laterally differing locations of the powder bed (22),
**characterized in that**
c) the electron beam installation (14) has a frit device (34, 35) with at least two electrodes (19, 30, 31), which, by applying an AC voltage between the at least two electrodes (19, 30, 31), generates an electromagnetic alternating field, which bonds the powdered material of the powder bed (22), at least in regions over the powder bed (22), wherein
d) the power and/or the frequency of the AC voltage of the frit device (34, 35) and the power of the electron beam (16) are selected so that the bonded powdered material is not dispersed during subsequent melting using the electron beam (16), wherein the powdered material is only bonded by the frit device (34, 35) at locations at which no processing takes place using the electron beam (16) in such a way that the powdered material can be detached again there, in particular by impacts, wherein
e) the frequency of the AC voltage of the frit device lies in regions greater than 5 kHz.

2. The electron beam installation as claimed in claim 1, **characterized in that** at least one electrode (19, 31) of the frit device (34, 35) is arranged at a fixed position inside the electron beam installation (10).

3. The electron beam installation as claimed in any one of the preceding claims, **characterized in that** at least two electrodes (30, 31) are arranged horizontally in a plane, in particular the same plane, parallel to an uppermost powder layer (28) of the powder bed (22).

4. The electron beam installation as claimed in any one of the preceding claims, **characterized in that** at least two electrodes (30, 31) of the frit device (34, 35) are arranged symmetrically in relation to a lateral region in which the electron beam (16) can be directed onto the powder bed (22).

5. The electron beam installation as claimed in any one of the preceding claims, **characterized in that** at least one electrode (30) of the frit device (34, 35) is configured to be moved along at least one axis above the powder bed (22).

6. The electron beam installation as claimed in any one of the preceding claims, **characterized in that** the powder container (18, 19, 20) has a powder bed table base (19), which is electrically conductive and at the same time forms an electrode of the frit device (34, 35).

7. The electron beam installation as claimed in any one of the preceding claims, **characterized in that** at least one electrode of the frit device (34, 35) is formed by the electron beam (16) itself, by the electron beam generator (14) being operated in a pulsed manner and/or the electron beam being deflected at high deflection speed.

8. A method for selective melting powdered material using an electron beam installation (10) to get a stable 3D structure (80), comprising the following steps:
a) providing an electron beam installation (10) comprising
- a powder container (18, 19, 20), which can accommodate a powder bed (22) made of the powdered material to be processed, and comprising
- an electron beam generator (14), which is configured to direct an electron beam (16) onto laterally differing locations of the powder bed (22);
b) applying an AC voltage between at least two electrodes (19, 30, 31) using a frit device (34, 35) to generate an electromagnetic alternating field, which bonds the powdered material of the powder bed (22), at least in regions over the powder bed (22), wherein the power and/or the frequency of the AC voltage of the frit device (34, 35) and the power of the electron beam (16) are selected so that the bonded powdered material is not dispersed during subsequent melting using the electron beam (16), wherein the powdered material is only bonded by the frit device (34, 35) at locations at which no processing takes place using the electron beam (16) in such a way that the powdered material can be detached again there, in particular by impacts, wherein the frequency of the AC voltage of the frit device lies in regions greater than 5 kHz;
c) selectively melting the powdered material using the electron beam (16).

## Revendications

1. Installation de faisceau électronique (10) qui est utilisée pour la fusion sélective de matériau pulvérulent pour parvenir à une structure tridimensionnelle stable (80), avec
a) un récipient de poudre (18, 19, 20) qui peut recevoir un lit de poudre (22) constitué du matériau pulvérulent à usiner, et avec
b) un générateur de faisceau électronique (14) qui est configuré pour diriger un faisceau électronique (16) vers des emplacements différents latéralement du lit de poudre (22),
**caractérisée en ce que**
c) l'installation de faisceau électronique (14) présente un dispositif cohéreur (34, 35) avec au moins deux électrodes (19, 30, 31) qui génère par application d'une tension alternative entre les au moins deux électrodes (19, 30, 31) au moins par régions par-dessus le lit de poudre (22) un champ alternatif électromagnétique qui relie le matériau pulvérulent du lit de poudre (22), dans laquelle
d) la puissance et/ou la fréquence de la tension alternative du dispositif cohéreur (34, 35) et la puissance du faisceau électronique (16) sont choisies de sorte que le matériau pulvérulent lié lors de la fusion subséquente avec le faisceau électronique (16) n'est pas soufflé, dans laquelle le matériau pulvérulent n'est lié à des emplacements auxquels aucun usinage avec le faisceau électronique (16) n'a lieu par le dispositif cohéreur (34, 35) que de sorte que le matériau pulvérulent peut y être de nouveau dissous, notamment par choc, et dans laquelle
e) la fréquence de la tension alternative du dispositif cohéreur se situe dans des régions supérieures à 5 kHz.

2. Installation de faisceau électronique selon la revendication 1, **caractérisée en ce qu'**au moins une électrode (19, 31) du dispositif cohéreur (34, 35) est disposée à une position fixe au sein de l'installation de faisceau électronique (10).

3. Installation de faisceau électronique selon une des revendications précédentes, **caractérisée en ce qu'**au moins deux électrodes (30, 31) sont disposées horizontalement dans un plan parallèle à une couche de poudre supérieure (28) du lit de poudre (22), notamment dans le même.

4. Installation de faisceau électronique selon une des revendications précédentes, **caractérisée en ce qu'**au moins deux électrodes (30, 31) du dispositif cohéreur (34, 35) sont disposées symétriquement à une région latérale dans laquelle le faisceau électronique (16) peut être dirigé vers le lit de poudre (22).

5. Installation de faisceau électronique selon une des revendications précédentes, **caractérisée en ce qu'**au moins une électrode (30) du dispositif cohéreur (34, 35) est configurée pour être déplacée le long d'au moins un axe au-dessus du lit de poudre (22).

6. Installation de faisceau électronique selon une des revendications précédentes, **caractérisée en ce que** le récipient de poudre (18, 19, 20) présente un plateau de table pour lit de poudre (19) qui est électriquement conducteur et forme simultanément une électrode du dispositif cohéreur (34, 35).

7. Installation de faisceau électronique selon une des revendications précédentes, **caractérisée en ce qu'**au moins une électrode du dispositif cohéreur (34, 35) est réalisée par le faisceau électronique (16) lui-même **en ce que** le générateur de faisceau électronique (14) est exploité de manière pulsée et/ou le faisceau électronique est balayé avec une vitesse de balayage élevée.

8. Procédé de fusion sélective de matériau pulvérulent avec une installation de faisceau électronique (10) pour parvenir à une structure tridimensionnelle stable (80), avec les étapes suivantes :
a) mise à disposition d'une installation de faisceau électronique (10) avec
- un récipient de poudre (18, 19, 20) qui peut recevoir un lit de poudre (22) constitué du matériau pulvérulent à usiner, et avec
- un générateur de faisceau électronique (14) qui est configuré pour diriger un faisceau électronique (16) vers des emplacements différents latéralement du lit de poudre (22) ;
b) application d'une tension alternative entre au moins deux électrodes (19, 30, 31) avec un dispositif cohéreur (34, 35) pour générer un champ alternatif électromagnétique au moins par régions par-dessus le lit de poudre (22), lequel relie le matériau pulvérulent du lit de poudre (22), dans lequel la puissance et/ou la fréquence de la tension alternative du dispositif cohéreur (34, 35) et la puissance du faisceau électronique (16) sont choisies de sorte que le matériau pulvérulent lié lors de la fusion subséquente avec le faisceau électronique (16) n'est pas soufflé, dans lequel le matériau pulvérulent n'est lié à des emplacements auxquels aucun usinage avec le faisceau électronique (16) n'a lieu par le dispositif cohéreur (34, 35) que de sorte que le matériau pulvérulent peut y être de nouveau dissous, notamment par choc, dans lequel la fréquence de la tension alternative du dispositif cohéreur se situe dans des régions supérieures à 5 kHz ;
c) fusion sélective du matériau pulvérulent avec le faisceau électronique (16).
